# EUROPÄISCHE PATENTSCHRIFT

(11) **EP 2 958 409 B1**
(45) Veröffentlichungstag und Bekanntmachung des Hinweises auf die Patenterteilung: **27.12.2017**
(21) Anmeldenummer: 14002077.7
(22) Anmeldetag: 17.06.2014
(51) Int. Cl.: H05K 5/06

(54) **Elektrischer Verteiler und Kunststoffspritzgussverfahren zu dessen Herstellung**
Electric distributor and a plastic injection moulding method for its production
Répartiteur électrique et procédé de moulage par injection de matière synthétique pour sa fabrication

(43) Veröffentlichungstag der Anmeldung: 23.12.2015
(73) Patentinhaber: WWS Technik in Form und Kunststoff GmbH, 71570 Oppenweiler (DE)
(72) Erfinder: Wolf, Joachim, 71570 Oppenweiler (DE)
(74) Vertreter: Wasmuth, Rolf

(56) Entgegenhaltungen:
- DE-A1- 19 504 608
- DE-A1- 19 755 767
- DE-A1-102009 046 872

## Beschreibung

Die Erfindung betrifft einen elektrischen Verteiler der im Oberbegriff des Anspruchs 1 angegebenen Gattung sowie ein Kunststoffspritzgussverfahren zur Herstellung eines elektrischen Verteilers.

Aus der EP 1 987 708 B1 ist ein Verfahren zum Herstellen eines elektrischen Verteilers mit einer Gehäuseschale und mit einer innerhalb der Gehäuseschale angeordneten Leiterplatte bekannt, wobei die Gehäuseschale mit einem Füllmaterial verfüllt ist, das die Leiterplatte umschließt. Das Füllmaterial besteht aus einer Vergussmasse, typischerweise Gießharz, die bei ca. 30° C bis 40°C mittels Vakuumbefüllung flüssig in die Gehäuseschale vergossen wird. Bis die Vergussmasse ausgehärtet ist, vergehen ca. 3 bis 12 Stunden. Während der Zeit des Aushärtens des Füllmaterials kann der Verteiler nicht weiterverarbeitet werden, so dass der Verteiler zwischengelagert werden muss. Damit ist die Herstellzeit eines solchen Verteilers mit Füllmaterial aus Vergussmasse vergleichsweise lang. Bei der industriellen Herstellung von Verteilern führt die lange Aushärtezeit und die Zwischenlagerung zu einem logistischen Mehraufwand.

Die DE-A 197 55 767 zeigt eine wannenförmige Gehäuseschale mit einer Steckereinheit für elektronische Kraftfahrzeug-Baugruppen. Die Leiterplatte wird in der Gehäuseschale mechanisch fixiert und die Steckereinheit mit dem Gehäuse verrastet. Steckerstifte werden in eine Anschlussvorrichtung der Platine eingeführt und verlötet. Danach wird die Baugruppe mit einem Epoxidharz vergossen.

In der DE-A 195 04 608 ist ein Positionssensor und ein Verfahren zur Herstellung des Positionssensors beschrieben. Nach Einschieben der Platine in das Gehäuse wird das Gehäuse mit Duroplastmasse verfüllt. Die Duroplastmasse wird bei Temperaturen von etwa 160° und Drücken von etwa 200 bar in ca. zwei Minuten polymerisieren. Der Abgang des Positionssensors kann vollständig aus Thermoplast gebildet werden, wobei der mit Thermoplast umspritzte Bereich frei von elektrischen Bauteilen sein soll.

Der Erfindung liegt die Aufgabe zugrunde, einen elektrischen Verteiler der gattungsgemäßen Art zu schaffen, der einfach und schnell herstellbar ist, ohne die auf der Leiterplatte angeordneten elektrischen Bauelemente bei der Herstellung zu beschädigen.

Eine weitere Aufgabe der Erfindung besteht darin, ein Verfahren zur Herstellung des elektrischen Verteilers anzugeben.

Diese Aufgabe wird bezüglich des elektrischen Verteilers durch einen elektrischen Verteiler mit den Merkmalen des Anspruchs 1 gelöst. Bezüglich des Verfahrens wird die Aufgabe durch ein Kunststoffspritzgussverfahren mit den Merkmalen des Anspruchs 9 gelöst.

Es ist vorgesehen, dass das in die Gehäuseschale verfüllte Füllmaterial aus einer Spritzgussmasse aus thermoplastischem Elastomer besteht. Die Spritzgussmasse ist in die Gehäuseschale gespritzt. Die Spritzgussmasse umschließt die Leiterplatte mit den elektrischen Bauelementen vollständig. Die Spritzgussmasse verbindet die Leiterplatte mechanisch mit der Gehäuseschale. Durch die Verwendung einer Spritzgussmasse ist ein sehr schnelles Aushärten des Füllmaterials beim Herstellen des Verteilers möglich. Obwohl üblicherweise die Temperatur der flüssigen Spritzgussmasse beim Einspritzen in die Gehäuseschale höher ist als die Temperatur einer Vergussmasse beim Eingießen in die Gehäuseschale, ist eine Beschädigung der elektrischen Bauelemente dadurch verhindert, dass die erhöhte Temperatur über nur einen sehr kurzen Zeitraum auf die elektrischen Bauelemente wirkt. Durch die Verwendung von thermoplastischem Elastomer kann eine bestimmte Shore-Härte, beispielsweise 85 Shore A, der ausgehärteten Spritzgussmasse erreicht werden, so dass die elektrischen Bauteile vor mechanischen Belastungen weitgehend geschützt sind und nicht beschädigt werden. Durch die vollständige Umschließung der Leiterplatte inklusive der elektrischen Bauelemente durch die Spritzgussmasse und durch die mechanische Verbindung der insbesondere harten Gehäuseschale mit der Spritzgussmasse kann ein Dichtheitsgrad der Schutzart IP 67 erzielt werden. Dadurch ist der elektrische Verteiler robust und bis zu einem entsprechenden, von der Schutzart IP 67 definierten, Dichtheitsgrad wasser- und staubgeschützt.

Zweckmäßig ist mindestens eines der elektrischen Bauelemente als aktives Bauelement ausgebildet. Damit ist ein aktiver elektrischer Verteiler gebildet. Eine Beschädigung der aktiven Bauelemente beim Einspritzen ist dadurch verhindert, dass die erhöhte Temperatur der Spritzgussmasse über nur einen sehr kurzen Zeitraum auf die elektrischen Bauelemente wirkt.

Vorteilhaft ist eines der aktiven Bauelemente als Lichtelement ausgebildet, und die Gehäuseschale weist eine Austrittsöffnung für das Licht auf, wobei die Spritzgussmasse eine lichtdurchlässige Spritzgussmasse ist und das Licht optisch zur Austrittsöffnung leitet. Die lichtdurchlässige Spritzgussmasse dient als Lichtleiter und leitet das Licht zur Austrittsöffnung. Üblicherweise, insbesondere beim Vergießen, müssen Dichtungstüllen eingesetzt werden, die einen Lichtkanal vom Lichtelement zu einer Austrittsöffnung bilden und beim Vergießen ein Eindringen von Füllmaterial in den Lichtkanal verhindern. Dichtungstüllen können bei vorliegender, mit der lichtdurchlässigen Spritzgussmasse verfüllten Gehäuseschale ersatzlos entfallen. Dadurch ist der Herstellprozess des Verteilers deutlich vereinfacht und schneller, da der Montageschritt des Anordnens von Dichtungstüllen entfällt.

Vorteilhaft ist zwischen mindestens einem der elektrischen Bauelemente und der Leiterplatte ein Zwischenraum gebildet, und ein Teil der Spritzgussmasse befindet sich im Zwischenraum. Dadurch ist das elektrische Bauelement weitgehend von der Spritzgussmasse umgeben, so dass eine sehr gute Abdichtung des elektrischen Bauelements erfolgt. Zudem ist das elektrische Bauelement, beispielsweise ein SMD-Bauteil, nicht nur über die Lötstelle mit der Leiterplatte, sondern auch über die Spritzgussmasse mechanisch mit der Leiterplatte verbunden. Dadurch ergibt sich eine sehr stabile mechanische Verbindung von Leiterplatte und elektrischem Bauteil, so dass auch bei mechanischer Belastung des Verteilers der Verteiler eine lange Lebensdauer aufweist.

Die wannenförmige Gehäuseschale umfasst zweckmäßig Seitenelemente und ein Bodenelement, und die Spritzgussmasse ist mit den Innenseiten der Seitenelemente und mit der Innenseite des Bodenelementes fest verbunden.

Vorteilhaft umfasst die Gehäuseschale eine topfförmige Aufnahme für den Abgang, und ein Teil der Spritzgussmasse bildet eine an der Wand der topfförmigen Aufnahme und an der Außenwand des Abgangs anliegende ringförmige Abdichtung. Die ringförmige Abdichtung dichtet zwischen einem auf den elektrischen Abgang aufgesetzten Stecker und dem Verteiler ab. Durch die angespritzte ringförmige Abdichtung ist ein zusätzlicher Dichtring, beispielsweise ein O-Ring, nicht erforderlich, da die Dichtung bei der Herstellung gleich mit angespritzt wird. Dadurch wird der Herstellprozess vereinfacht.

Vorzugsweise ist in der topfförmigen Aufnahme eine Durchflussöffnung angeordnet, und die ringförmige Abdichtung ist über die Durchflussöffnung mit der in der Gehäuseschale verfüllten Spritzgussmasse verbunden. Durch die Durchflussöffnung kann die in die Gehäuseschale verfüllte Spritzgussmasse fließen, so dass die ringförmige Abdichtung automatisch beim Spritzgießen entsteht. Ein zusätzlicher Spritzkanal im Spritzgusswerkzeug der Spritzgießmaschine, der nur für die ringförmige Abdichtung vorgesehen wäre, kann entfallen.

Zweckmäßig ist der Verteiler mindestens teilweise mit einer Deckschicht umgeben. Eine solche Deckschicht kann beispielsweise ein lebensmittelechter Werkstoff, ein brandhemmender Kunststoff oder dergleichen sein. Durch die Deckschicht ist der dichte Verteiler für einen weiteren Anwendungszweck, nämlich beispielsweise zur Verwendung in der Lebensmittelindustrie oder in einer brandgefährdeten Umgebung, veredelt.

Für ein Kunststoffspritzgussverfahren zur Herstellung eines elektrischen Verteilers mit einer transparenten Spritzgussmasse aus thermoplastischem Elastomer, und mit einer mit elektrischen Bauelementen bestückten Leiterplatte, wobei insbesondere mindestens eines der elektrischen Bauelemente als aktives Bauelement ausgebildet ist, ist vorgesehen, dass die Leiterplatte einschließlich der elektrischen Bauelemente mit der Spritzgussmasse umspritzt wird, so dass die Leiterplatte einschließlich der elektrischen Bauelemente von der Spritzgussmasse umschlossen wird. Die mit den elektrischen Bauelementen bestückte Leiterplatte wird in eine Kavität eines Spritzgusswerkzeugs einer Spritzgießmaschine angeordnet, und das Granulat als Rohmaterial des thermoplastischen Elastomers wird zu einer Schmelze durch Erhitzen des Granulats in einem Heizbereich eines Plastifizierzylinders der Spritzgießmaschine auf eine Heiztemperatur von mindestens 170° C, insbesondere von mindestens 200° C, und vorteilhaft von mindestens 240° C verflüssigt. Die Schmelze wird zu einer geschlossenen Düse des Plastifizierzylinders gefördert und ein Einspritzdruck von höchstens 500 bar, insbesondere von höchstens 300 bar, besonders vorteilhaft von höchstens 200 bar wird in der Schmelze aufgebaut. Anschließend wird die Düse geöffnet, und die Schmelze wird in die Kavität eingespritzt, so dass die Leiterplatte umspritzt wird. Schließlich erstarrt die Schmelze zur formstabilen Spritzgussmasse. Das vollständige Erstarren der Schmelze findet vorteilhaft sowohl innerhalb als auch außerhalb des Spritzgusswerkzeugs statt. Durch die hohe Heiztemperatur, die höher ist, als zur Verflüssigung und Bearbeitung des thermoplastischen Elastomers in einem konventionellen Spritzgussverfahren üblich, wird erreicht, dass die Schmelze vergleichsweise dünnflüssig und insbesondere nicht zähflüssig ist. Dadurch ist der Einspritzdruck vergleichsweise sehr niedrig. In einem konventionellen Spritzgussverfahren beträgt der Einspritzdruck 800 bar bis 2000 bar. Durch den niedrigen Einspritzdruck von höchstens 500 bar werden die elektrischen Bauelemente beim Einspritzen der Schmelze nicht beschädigt. Insbesondere drucksensitive aktive elektrische Bauelemente, wie beispielsweise ein Quartz, werden in diesem Verfahren nicht beschädigt. Obwohl die Heiztemperatur in diesem Verfahren vergleichsweise hoch ist, werden die elektrischen Bauelemente dadurch nicht beschädigt, dass die hohe Temperatur der Schmelze nur über einen kurzen Zeitraum auf die elektrischen Bauteile wirkt. Die Wärme wird schnell auf das Spritzgusswerkzeug übertragen, so dass der Wärmeeintrag auf die elektrischen Bauteile minimiert ist. Die Kombination von Heiztemperatur, die deutlich höher als üblich ist, und Einspritzdruck, der deutlich niedriger als üblich ist, ermöglicht, dass ein, insbesondere aktiver, elektrischer Verteiler im Kunststoffspritzgussverfahren hergestellt werden kann, ohne dass die, insbesondere aktiven, elektrischen Bauelemente beim Herstellen beschädigt werden. Dadurch werden bei diesem Herstellungsverfahren nahezu keine Rückläufer, also keine beschädigten Verteiler, produziert.

Vorteilhaft ist zwischen mindestens einem der elektrischen Bauelemente und der Leiterplatte ein Zwischenraum gebildet, und beim Umspritzen fließt ein Teil der Schmelze in den Zwischenraum. Dadurch wird die Dichtheit, insbesondere im Bereich der elektrischen Bauteile, erhöht. Außerdem wird das elektrische Bauteil mechanisch fest mit der Leiterplatte verbunden. Durch die hohe Heiztemperatur sowie durch den geringen Einspritzdruck ist zudem gewährleistet, dass die Schmelze vergleichsweise einfach in den Zwischenraum eindringen kann, ohne eine große mechanische Kraft auf das elektrische Bauteil auszuüben. Dadurch platzen die Bauteile nicht von der Leiterplatte weg.

Zweckmäßig wird eine wannenförmige Gehäuseschale mit der in der Gehäuseschale angeordneten Leiterplatte in die Kavität des Spritzgusswerkzeugs der Spritzgießmaschine angeordnet, und die Schmelze wird in die Gehäuseschale eingespritzt und umschließt die Leiterplatte. Die Schmelze erstarrt zweckmäßig in der Gehäuseschale zur Spritzgussmasse. Die wannenförmige Gehäuseschale besteht zweckmäßig aus einem harten, lichtundurchlässigen Kunststoff. Die Gehäuseschale kann auch aus dem gleichen Material wie das Material der Spritzgussmasse bestehen. Die Gehäuseschale bietet einen zusätzlichen Schutz des Verteilers, beispielweise vor mechanischen Einwirkungen. Beim Herstellen gewährleistet die Gehäuseschale, dass die Schmelze in die Gehäuseschale eingespritzt werden kann und sich mit der Schmelze fest verbindet.

Vorteilhaft ist mit der Leiterplatte ein elektrischer Abgang elektrisch verbunden, und die Gehäuseschale umfasst eine topfförmige Aufnahme für den Abgang, und der in der Aufnahme angeordnete Abgang wird aus der Gehäuseschale geführt. Vorteilhaft ist eine Durchflussöffnung in der topfförmigen Aufnahme angeordnet, und beim Einspritzen fließt die Schmelze durch die Durchflussöffnung und legt sich ringförmig zwischen Abgang und Gehäuseschale. Aufgrund der Durchflussöffnung ist im Herstellungsprozess kein zusätzlicher Zugang für die Schmelze in der Kavität der Spritzgussform zum Einspritzen von Schmelze in die topfförmige Aufnahme erforderlich, da die Schmelze durch die Durchflussöffnung treten kann. Die Schmelze muss demnach lediglich in die wannenförmige Gehäuseschale gespritzt werden. Zusätzlich, nach dem Aushärten der Schmelze, ist neben der ringförmigen Abdichtung eine mechanische Verbindung zwischen Abgang und Gehäuseschale durch die Spritzgussmasse erfolgt. Der Verteiler inklusive Abgang ist in sich stabil, staub- und wassergeschützt, und zusätzliche Bauteile wie beispielsweise ein O-Ring, der den Abgang zu einem am Abgang angeschlossenen Stecker abdichtet, ist aufgrund der angespritzten ringförmigen Abdichtung nicht erforderlich.

Zweckmäßig ist mindestens eines der elektrischen Bauteile als aktives Bauelement ausgebildet. Zweckmäßig ist eines der aktiven Bauelemente als Lichtelement ausgebildet, und die Spritzgussmasse ist lichtdurchlässig und dient als Lichtleiter. Zweckmäßig werden die vom Lichtelement ausgesendeten Lichtsignale von der Spritzgussmasse geleitet. Dadurch ist das Kunststoffspritzgussverfahren deutlich vereinfacht, da zusätzliche Bauteile, wie beispielsweise eine Tülle, die einen Lichtkanal vom Lichtelement zur Lichtöffnung bildet, nicht erforderlich sind. Insbesondere beim Spritzgussverfahren, bei welchem die Schmelze unter relativ hoher Temperatur und relativ hohem Druck - im Vergleich zu einem Gießverfahren - in die wannenförmige Gehäuseschale eingespritzt wird und dadurch die Position der Tülle verschieben kann, erleichtert die lichtdurchlässige Spritzgussmasse das Herstellverfahren, da die Tülle entfällt. Außerdem entfällt der Montageschritt der Anordnung der Tülle zwischen Leiterplatte und Gehäuseschale bei der Herstellung.

Vorteilhaft ist die Schmelze in höchstens drei Minuten zur formstabilen Spritzgussmasse ausgehärtet. Dadurch kann der Verteiler relativ schnell weiterverarbeitet, beispielsweise verpackt, werden. Dadurch ist die Herstellzeit des Verteilers, welcher nach diesem Kunststoffspritzgussverfahren hergestellt wird, deutlich geringer als die Herstellzeit des Verteilers, der im Gussverfahren hergestellt wird.

Vorzugsweise wird nach dem Erstarren der Schmelze der Verteiler mindestens teilweise mit einer Deckschicht, beispielsweise mit einem lebensmittelechten Werkstoff, einem brandhemmenden Kunststoff oder dergleichen, umspritzt. Der dichte Verteiler wird dadurch für einen weiteren Einsatzzweck, beispielsweise in der Lebensmittelindustrie, veredelt.

Ein Ausführungsbeispiel wird im Nachfolgenden anhand der Zeichnungen erläutert. Es zeigen:
- Fig. 1: eine perspektivische Ansicht von oben auf einen aktiven elektrischen Verteiler,
- Fig. 2: eine perspektivische Ansicht von unten auf den Verteiler,
- Fig. 3: eine Schnittdarstellung durch den Verteiler mit einer Gehäuseschale, mit einer Leiterplatte, mit elektrischen Bauelementen und mit einem elektrischen Abgang,
- Fig. 4: eine schematische Darstellung von Durchflussöffnungen am Boden einer an der Gehäuseschale angeordneten topfförmigen Aufnahme für den Abgang,
- Fig. 5: eine perspektivische Ansicht von oben auf die Gehäuseschale,
- Fig. 6: eine perspektivische Ansicht von unten auf die Gehäuseschale,
- Fig. 7: einen schematischen Schnitt durch eine Spritzgießmaschine zur Herstellung des elektrischen Verteilers.

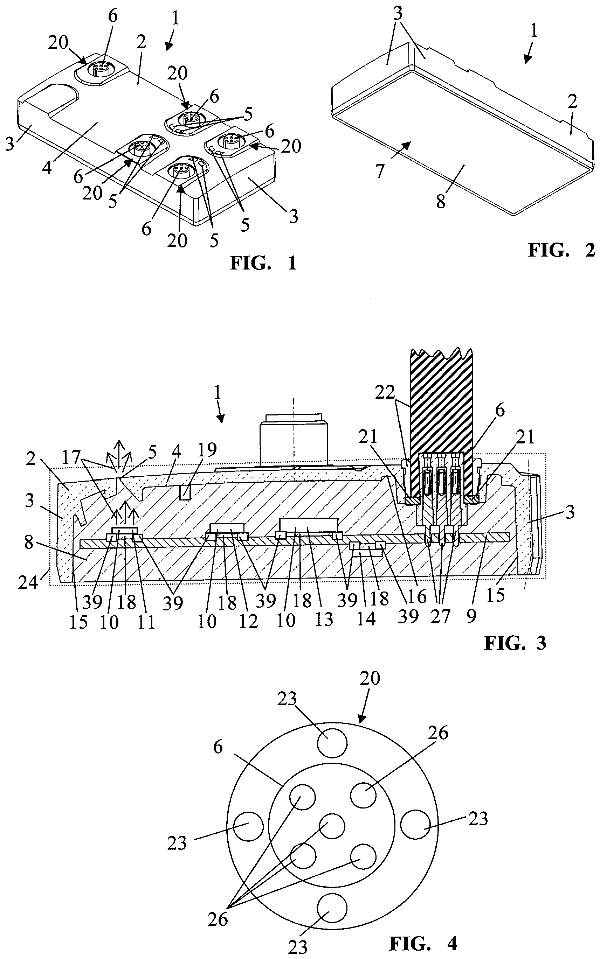

Fig. 1 zeigt einen aktiven elektrischen Verteiler 1. Der aktive elektrische Verteiler 1 umfasst eine wannenförmige Gehäuseschale 2. Die wannenförmige Gehäuseschale 2 besteht aus einem harten, lichtundurchlässigen Material, beispielsweise aus einem harten, lichtundurchlässigen Kunststoff. Die wannenförmige Gehäuseschale 2 umfasst vier Seitenelemente 3 und ein Bodenelement 4. Jeweils zwei benachbarte Seitenelemente 3 sind orthogonal zueinander angeordnet. Alle Seitenelemente 3 stehen rechtwinklig zum Bodenelement 4, so dass die Gehäuseschale 2 die Wannenform erhält. Im Ausführungsbeispiel sind die vier Seitenelemente 3 mit dem Bodenelement 4 derart verbunden, dass die wannenförmige Gehäuseschale 2 ein etwa quaderförmiges Innenvolumen des Verteilers 1 begrenzt. Im Innenvolumen wird, wie weiter unten beschrieben, eine Leiterplatte 9 (Fig. 3) angeordnet und das Innenvolumen wird, wie weiter unten beschrieben, mit einem Füllmaterial 7 (Fig. 2) verfüllt. Am Bodenelement 4 sind mehrere Austrittsöffnungen 5 für Licht vorgesehen. Über die Austrittsöffnungen 5 können verschiedene Betriebszustände des elektrischen Verteilers 1 angezeigt werden.

Der aktive elektrische Verteiler 1 umfasst mehrere elektrische Abgänge 6. Im Ausführungsbeispiel ist jeder der elektrischen Abgänge 6 durch die Gehäuseschale 2, nämlich durch das Bodenelement 4, geführt. An jeden der elektrischen Abgänge 6 kann ein Stecker mit einem Kabel angeschlossen werden, um den elektrischen Verteiler 1 mit einem weiteren, nicht gezeigten elektrischen Gerät zu verbinden.

Die wannenförmige Gehäuseschale 2 ist mit dem in Fig. 2 gezeigten Füllmaterial 7 verfüllt. Das Füllmaterial 7 besteht aus einer lichtdurchlässigen Spritzgussmasse 8 aus thermoplastischem Elastomer. Im Ausführungsbeispiel ist als thermoplastisches Elastomer Polyurethan verwendet. Das thermoplastische Elastomer erreicht eine Shore-Härte von 85 Shore A. Die Spritzgussmasse 8 ist in die Gehäuseschale 2 gespritzt und schließt mit den Seitenelementen 3 bündig ab und füllt insbesondere das Innenvolumen des Verteilers 1 vollständig aus. Üblicherweise wird das Füllmaterial 7 bei aktiven elektrischen Verteilern 1 in die Gehäuseschale 2 vergossen, was zeitaufwändig ist. Im vorliegenden Ausführungsbeispiel wird das thermoplastische Elastomer in die Gehäuseschale 2 gespritzt, so dass der aktive elektrische Verteiler 1 einfach und schnell herstellbar ist.

Der aktive elektrische Verteiler 1 umfasst die in Fig. 3 gezeigte, innerhalb der Gehäuseschale 2 angeordnete Leiterplatte 9. Auf der Leiterplatte 9 sind aktive elektrische Bauelemente 10 angeordnet. Neben aktiven elektrischen Bauelementen 10 ist an der Leiterplatte 9 auch ein passives elektrisches Bauelement 14 angeordnet. Im Ausführungsbeispiel sind die elektrischen Bauelemente 10, 14 SMD-Bauteile. Im Ausführungsbeispiel nach Fig. 3 sind die elektrischen Bauelemente 10, 14 auf beiden Seiten der Leiterplatte 9 angeordnet. In einem weiteren Ausführungsbeispiel können die elektrischen Bauelemente 10 auch nur auf einer Seite der Leiterplatte 9, beispielsweise auf der der Gehäuseschale 4 zugewandten Seite der Leiterplatte 9 angeordnet sein. Die aktiven elektrischen Bauelemente 10 umfassen ein Lichtelement 11, beispielsweise eine LED, einen Quartz 12, einen Prozessor 13 und dergleichen. Das passive elektrische Bauelement 14 ist beispielsweise ein Widerstand. Sämtliche elektrische Bauelemente 10, 14 sowie der elektrische Abgang 6 sind elektrisch mit der Leiterplatte verbunden. Der aktive elektrische Verteiler 1 ist derart aufgebaut, dass der Verteiler 1 autark und damit ohne Verbindung zu einem Server arbeiten kann.

Die Spritzgussmasse 8 umschließt die Leiterplatte 9 inklusive der elektrischen Bauelemente 10, 14 vollständig. Die Spritzgussmasse 8 schließt bündig mit den Enden der Seitenelemente 3 ab. Die Spritzgussmasse ist mit den Innenseiten 15 der Seitenelemente 3 und mit der Innenseite 16 des Bodenelementes 4 fest verbunden. Dadurch verbindet die Spritzgussmasse 8 die Leiterplatte 9 mechanisch mit der Gehäuseschale 2. Ein Eintreten von Schmutz und Wasser in den Verteiler 1 ist dadurch wirkungsvoll unterbunden, so dass der Verteiler 1 den geforderten Dichtheitsgrad der Schutzklasse IP 67 erfüllt.

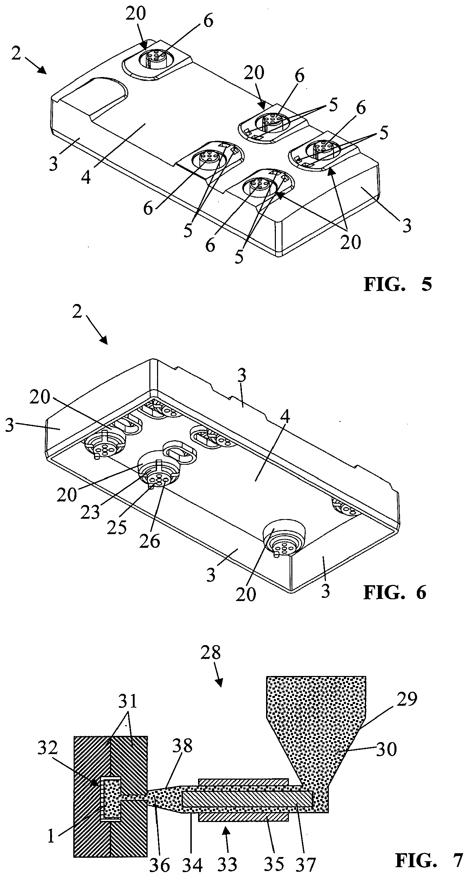

Obwohl bei dem Spritzgussverfahren hohe Temperaturen beim Einspritzen des Füllmaterials 7 in die Gehäuseschale 2 entstehen, werden die auf der Leiterplatte 9 angeordneten elektrischen Bauelemente 10, 14 bei der Herstellung nicht beschädigt, da die elektrischen Bauteile 10, 14 nur über eine sehr kurze Zeit der hohen thermischen Belastung ausgesetzt sind und in dieser Zeit keinen thermischen Schaden nehmen. Im vorliegenden Spritzgussverfahren sind die Drücke, die beim Einspritzen des Füllmaterials 7 in die Gehäuseschale 2 entstehen und auf die auf der Leiterplatte 9 angeordneten elektrischen Bauelemente 10, 14 wirken, verglichen mit konventionellen Spritzgussverfahren gering. Dadurch entstehen bei der Herstellung keine mechanischen Schäden an den elektrischen Bauteilen 10, 14. Damit kann das Füllmaterial 7 in die Gehäuseschale 2 gespritzt werden, ohne dass die elektrischen Bauelemente 10, 14 beschädigt werden. Das genaue Herstellverfahren ist weiter unten in der Beschreibung zu Fig. 7 erläutert.

Im Ausführungsbeispiel leitet die lichtdurchlässige Spritzgussmasse 8 Licht 17, welches vom Lichtelement 11 ausgestrahlt wird, zur Lichtöffnung 5. Zusätzliche Vorkehrungen, beispielsweise Dichtungstüllen, die einen Lichtkanal vom Lichtelement 11 zur Lichtöffnung 5 bilden, sind nicht erforderlich, da die lichtdurchlässige Spritzgussmasse 8 als Lichtleiter dient.

Zwischen den elektrischen Bauelementen 10, 14 und der Leiterplatte 9 ist jeweils ein Zwischenraum 18 gebildet. Der Zwischenraum 18 ist im Ausführungsbeispiel vollständig mit Spritzgussmasse 8 gefüllt. Dadurch sind die elektrischen Bauelemente 10, 14 bis auf die direkte Befestigung über elektrische Anschlüsse 39 mit der Leiterplatte 9 vollständig von der Spritzgussmasse 8 umgeben. Dadurch ist gewährleistet, dass die elektrischen Bauelemente 10, 14 mechanisch fest mit der Leiterplatte 9 verbunden sind. Außerdem sind die elektrischen Bauelemente 10, 14, da vollständig von der Spritzgussmasse 8 umgeben, wasser- und staubgeschützt im Verteiler 1 angeordnet.

Beim Einspritzen der Spritzgussmasse 8 in die Gehäuseschale 2 können Lunker 19 entstehen. Im Ausführungsbeispiel ist der Lunker 19 vollständig im Verteiler 1 angeordnet. Der Lunker 19 ist von der Spritzgussmasse 8 und der Gehäuseschale 2 begrenzt. Der Lunker 19 beeinträchtigt dadurch nicht die Dichtheit des Verteilers 1, so dass zusätzliche Maßnahmen beim Herstellen, insbesondere während dem Spritzgussverfahren, zur Vermeidung von Lunkern 19 nicht erforderlich sind. In einem weiteren Ausführungsbeispiel können beim Herstellen Maßnahmen getroffen werden, die ein Entweichen der beim Spritzgießen eingeschlossenen Luft ermöglichen, so dass keine Lunker 19 gebildet werden.

Die Gehäuseschale 2 umfasst eine topfförmige Aufnahme 20 für den Abgang 6. Die topfförmige Aufnahme 20 ist einteilig mit dem Bodenelement 4 ausgebildet. Die topfförmige Aufnahme ragt in Richtung auf die Leiterplatte 9, also ins Innere des Verteilers 1. Zwischen der Wand der topfförmigen Aufnahme 20 und der Außenwand des elektrischen Abgangs 6 ist eine aus Spritzgussmasse 8 bestehende ringförmige Abdichtung 21 gebildet. Die ringförmige Abdichtung 21 dient dazu, dass ein auf den Abgang 6 aufgesteckter Stecker 22 gegenüber dem Verteiler 1 abgedichtet ist. Ein zusätzlicher O-Ring, wie er üblicherweise zur Abdichtung zwischen Stecker 22 und Verteiler 1 verwendet wird, ist nicht erforderlich.

Um die ringförmige Abdichtung 21 möglichst einfach im Spritzgussverfahren einspritzen zu können, sind in der topfförmigen Aufnahme 20 in Fig. 4 schematisch gezeigte Durchflussöffnungen 23 vorgesehen. Die Spritzgussmasse 8 wird im Spritzgussverfahren in die Gehäuseschale 2 eingespritzt, fließt durch die Durchflussöffnungen 23 und verteilt sich ringförmig zwischen Abgang 6 und topfförmiger Aufnahme 20. Die ringförmige Abdichtung 21 ist demnach über die Durchflussöffnungen 23 mit der in der Gehäuseschale 2 verfüllten Spritzgussmasse 8 verbunden.

In den Fig. 5 und 6 ist in perspektivischer Ansicht die an dem Bodenelement 4 ausgebildete topfförmige Aufnahme 20 dargestellt. Die topfförmige Aufnahme 20 ragt ähnlich einem Kegelstumpf in das Innere des Verteilers 1. Zwischen einem an der topfförmigen Aufnahme 20 befestigten Hilfselement 25 und der topfförmigen Aufnahme 20 sind die Durchflussöffnungen 23 angeordnet. Das Hilfselement umfasst Bohrungen 26, in welche in Fig. 3 gezeigte Pins 27 des elektrischen Abgangs 6 geführt sind. Die Pins 27 sind mit der Leiterplatte 9 elektrisch verbunden.

In einem weiteren Ausführungsbeispiel kann der Verteiler 1 mindestens teilweise mit einer in Fig. 4 schematisch angedeuteten Deckschicht 24 umgeben sein. Die Deckschicht 24 kann beispielsweise ein lebensmittelechter Werkstoff, ein brandhemmender Werkstoff mit V0-Brandschutzeigenschaften oder dergleichen sein und den dichten Verteiler 1 für weitere Verwendungszwecke veredeln.

Fig. 7 zeigt eine Spritzgießmaschine 28, mit welcher der aktive elektrische Verteiler 1 hergestellt wird. Die Spritzgießmaschine 28 umfasst einen Einfülltrichter 29, in welchem das Granulat 30 als Rohmaterial des thermoplastischen Elastomers eingefüllt wird. Die Spritzgießmaschine 28 umfasst ein Spritzgusswerkzeug 31 mit einer Kavität 32. Die wannenförmige Gehäuseschale 2 wird zusammen mit der in der Gehäuseschale 2 angeordneten Leiterplatte 9 in der Kavität 32 angeordnet. Die Spritzgießmaschine 28 umfasst einen Heizbereich 33 eines Plastifizierzylinders 34, in welchem das Granulat 30 verflüssigt wird. Hierzu sind im Heizbereich 33 Heizelemente 35 vorgesehen. Das Granulat wird auf eine Heiztemperatur T von mindestens 170° C, insbesondere von mindestens 200° C und insbesondere von mindestens 240° C erhitzt und zu einer Schmelze 36 verflüssigt. Damit wird das Granulat auf eine Heiztemperatur T erhitzt, die höher ist als die übliche Verarbeitungstemperatur eines thermoplastischen Elastomers, beispielsweise Polyurethan. Bei solch hohen Heiztemperaturen T besteht die Gefahr, dass der Werkstoff zerstört wird. Dennoch wird in diesem Spritzgussverfahren das Granulat auf diese hohe Heiztemperatur T erhitzt, da sich die hohe Heiztemperatur T vorteilhaft auf das Spritzgießverfahren auswirkt, wie nachfolgend beschrieben wird.

Die Spritzgießmaschine 28 umfasst eine Schnecke 37, die das Granulat 30 in den Heizbereich 33 fördert und die Schmelze 36 zu einer Düse 38 fördert. Die Düse 38 ist zunächst geschlossen. Durch die kontinuierliche Förderung der Schmelze 36 zur Düse wird ein Einspritzdruck p von höchstens 500 bar, insbesondere von höchstens 300 bar, und insbesondere von höchstens 200 bar in der Schmelze 36 aufgebaut. Nach Aufbau des gewünschten Einspritzdrucks wird die mit dem Spritzgusswerkzeug 31 verbundene Düse 38 geöffnet, und die Schmelze 36 wird in die Kavität 32 eingespritzt. Somit wird die Schmelze 36 in die Gehäuseschale 2 eingespritzt, und die Leiterplatte wird von der Schmelze umschlossen. Dadurch, dass die Schmelze 36 vergleichsweise heiß und dadurch dünnflüssig ist, kann der Einspritzdruck p vergleichsweise niedrig gewählt werden. Durch einen niedrigen Einspritzdruck p ist die mechanische Belastung auf die elektrischen Bauelemente 10, 14 beim Einspritzen der Schmelze 36 gering. Eine mechanische Beschädigung der elektrischen Bauelemente 10, 14 aufgrund des Einspritzdrucks p ist unterbunden.

Schließlich erstarrt die Schmelze 36 in der Gehäuseschale 2 zur formstabilen Spritzgussmasse 8. Hierbei nimmt das Spritzgusswerkzeug 31 einen Teil der Wärmeenergie der Schmelze 36 auf. Obwohl die zwischen Schmelze 36 und Spritzgusswerkzeug 31 angeordnete Gehäuseschale 2 wie ein thermischer Isolator wirkt und einen Wärmeabfluss beim Erstarren der Schmelze 36 in das Spritzgusswerkzeug 31 erschwert, nehmen bei diesem Herstellverfahren die elektrischen Bauelemente 10, 14 keinen thermischen Schaden, da das Erstarren der Schmelze 36 zur formstabilen Spritzgussmasse 8 höchstens drei Minuten dauert. Damit ist die Zeitdauer, in der die elektrischen Bauteile 10, 14 einer hohen Temperatur ausgesetzt sind, gering und ein thermischer Schaden kann trotz der vergleichsweise hohen Temperatur in der Schmelze 36 nicht entstehen.

Auch dadurch, dass die Gehäuseschale 2 eine Wannenform aufweist, kann auf der dem Bodenelement 4 abgewandten Seite des Verteilers 1 viel Wärme aus der Schmelze 36 in das Spritzgusswerkzeug 31 fließen. Damit kann gewährleistet werden, dass in der Zeit des Erstarrens der Schmelze 36 der Wärmeeintrag von der Schmelze 36 auf die elektrischen Bauelemente 10, 14 gering ist und die elektrischen Bauelemente 10, 14 keinen thermischen Schaden erleiden.

Beim Einspritzen der Schmelze 36 in die Gehäuseschale 2 und beim Umspritzen der Leiterplatte 9 tritt ein Teil der Schmelze 36 in den Zwischenraum 18 zwischen den elektrischen Bauelementen 10, 14 und der Leiterplatte 9 ein. Durch die vergleichsweise hohe Temperatur der Schmelze 36 ist die Schmelze 36 dünnflüssig, so dass die Schmelze 36 ohne große mechanische Belastung auf die elektrischen Bauelemente 10, 14 in den Zwischenraum 18 fließen kann. Eine mechanische Beschädigung der elektrischen Bauelemente 10, 14, beispielsweise ein Abplatzen der Bauelemente 10, 14 von der Leiterplatte 9 beim Einspritzen, ist dadurch unterbunden.

Beim Einspritzen der Schmelze 36 fließt die Schmelze 36 durch die Durchflussöffnung 32 und legt sich ringförmig zwischen Abgang 6 und Gehäuseschale 2. Nach Erstarren der Schmelze 36 zur formstabilen Spritzgussmasse 8 kann der Verteiler 1 weiter bearbeitet werden. Beispielsweise kann der Verteiler 1 mit einer Deckschicht 24 umspritzt und damit für weitere Anwendungszwecke veredelt werden.

Zweckmäßig ist die Austrittsöffnung 5 im Bodenelement 4 angeordnet. Dadurch kann gewährleistet werden, dass die Spritzgussmasse 8 vom Lichtelement 11 bis zur Austrittsöffnung 5 einen ununterbrochenen Lichtleiter bildet. Durch die Anordnung der Austrittsöffnung 5 im Bodenelement 4 ist zudem gewährleistet, dass die vom Lichtelement 11 ausgesendeten Lichtsignale, die aus der Austrittsöffnung 5 treten, gut sichtbar sind.

Zweckmäßig ist der Abgang 6 durch das Bodenelement 4 geführt. Die Spritzgussmasse 8 dichtet vorteilhaft den elektrischen Abgang 6 zur Gehäuseschale 2 hin ab. Durch die Anordnung des Abgangs 6 am Bodenelement 4 ist der Abgang 6 von außen einfach zugänglich, so dass beispielsweise ein Stecker einfach mit dem Abgang 6 elektrisch verbunden werden kann.

In einem weiteren Ausführungsbeispiel kann der Verteiler 1 auch nur passive elektrische Bauteile 14 und keine aktiven elektrischen Bauteile 10 umfassen.

In einem weiteren Ausführungsbeispiel kann die Gehäuseschale 2 auch aus dem gleichen Material wie das Material der Spritzgussmasse 8 bestehen. Die Gehäuseschale 2 kann in einem weiteren Ausführungsbeispiel auch zusammen mit dem Füllmaterial 7 um die Leiterplatte 9 gespritzt sein. Damit sind das Füllmaterial 7 und die Gehäuseschale 2 einteilig ausgebildet und in einem Arbeitsgang hergestellt. Die harte Gehäuseschale 2 entfällt hierbei.

In einem weiteren Ausführungsbeispiel wird die Leiterplatte 9 mit einer Haltevorrichtung, beispielsweise einem Gerüst, einem Haltestift, oder dgl. Haltevorrichtung, in der Kavität 32 angeordnet. Die Haltevorrichtung wird mit dem Spritzgusswerkzeug 31 verbunden, so dass die Position der Leiterplatte 9 in der Kavität 32 festgelegt ist. Anschließend wird die Leiterplatte 9 inklusive Haltevorrichtung mit der Schmelze 36 umspritzt. In einem weiteren Ausführungsbeispiel ersetzt die Haltevorrichtung die Gehäuseschale 2. Die harte Gehäuseschale 2 als zusätzliches Bauteil entfällt hierbei.

## Patentansprüche

1. Elektrischer Verteiler (1) mit einer wannenförmigen Gehäuseschale (2),
- mit einer innerhalb der Gehäuseschale (2) angeordneten Leiterplatte (9),
- wobei die Leiterplatte (9) passive und/oder aktive elektrische Bauelemente (10, 14) trägt,
- und mit einem mit der Leiterplatte (9) elektrisch verbundenen elektrischen Abgang (6),
- wobei der elektrische Abgang (6) durch die Gehäuseschale (2) geführt ist,
- und wobei die Gehäuseschale (2) mit einem Füllmaterial (7) verfüllt ist,
**dadurch gekennzeichnet,**
- **dass** das Füllmaterial (7) aus einer Spritzgussmasse (8) aus thermoplastischem Elastomer besteht,
- **dass** die Spritzgussmasse (8) in die Gehäuseschale (2) gespritzt ist,
- **dass** die Spritzgussmasse (8) die Leiterplatte (9) mit den elektrischen Bauelementen (10, 14) vollständig umschließt,
- und **dass** die Spritzgussmasse (8) die Leiterplatte (9) mechanisch mit der Gehäuseschale (2) verbindet.

2. Verteiler nach Anspruch 1,
**dadurch gekennzeichnet, dass** eines der aktiven Bauelemente (10) als Lichtelement (11) ausgebildet ist und die Gehäuseschale (2) eine Austrittsöffnung (5) für das Licht (17) aufweist, wobei die Spritzgussmasse (8) eine lichtdurchlässige Spritzgussmasse (8) ist und das Licht (17) optisch zur Austrittsöffnung (5) leitet.

3. Verteiler nach Ansprüche 1 oder 2,
**dadurch gekennzeichnet, dass** zwischen mindestens einem der elektrischen Bauelemente (10, 14) und der Leiterplatte (9) ein Zwischenraum (18) gebildet ist, und dass sich ein Teil der Spritzgussmasse (8) im Zwischenraum (18) befindet.

4. Verteiler nach einem der Ansprüche 1 bis 3,
**dadurch gekennzeichnet, dass** die wannenförmige Gehäuseschale (2) Seitenelemente (3) und ein Bodenelement (4) umfasst, und dass die Spritzgussmasse (8) mit den Innenseiten (15) der Seitenelemente (3) und mit der Innenseite (16) des Bodenelements (4) fest verbunden ist.

5. Verteiler nach einem der Ansprüche 1 bis 4,
**dadurch gekennzeichnet, dass** die Gehäuseschale (2) eine topfförmige Aufnahme (20) für den Abgang (6) umfasst, und dass ein Teil der Spritzgussmasse (8) eine an der Wand der topfförmigen Aufnahme (20) und an der Außenwand des Abgangs (6) anliegende ringförmige Abdichtung (21) bildet.

6. Verteiler nach Anspruch 5,
**dadurch gekennzeichnet, dass** in der topfförmigen Aufnahme (20) eine Durchflussöffnung (23) angeordnet ist, und dass die ringförmige Abdichtung (21) über die Durchflussöffnung (23) mit der in der Gehäuseschale (2) verfüllten Spritzgussmasse (8) verbunden ist.

7. Verteiler nach einem der Ansprüche 1 bis 6,
**dadurch gekennzeichnet, dass** der Verteiler (1) mindestens teilweise mit einer Deckschicht (24) umgeben ist.

8. Kunststoffspritzgussverfahren zur Herstellung eines elektrischen Verteilers (1)
- mit einer transparenten Spritzgussmasse (8) aus thermoplastischem Elastomer
- und mit einer mit passiven und/oder aktiven elektrischen Bauelementen (10, 14) bestückten Leiterplatte (9),
- wobei die Leiterplatte (9) einschließlich der elektrischen Bauelemente (10, 14) mit der Spritzgussmasse (8) umspritzt wird,
- so dass die Leiterplatte (9) einschließlich der elektrischen Bauelemente (10, 14) von der Spritzgussmasse (8) umschlossen wird,
- mit den folgenden Verfahrensschritten:
• Anordnen der mit den elektrischen Bauelementen (10, 14) bestückten Leiterplatte (9) in eine Kavität (32) eines Spritzgusswerkzeugs (31) einer Spritzgießmaschine (28),
• Verflüssigen des Granulats (30) als Rohmaterial des thermoplastischen Elastomers zu einer Schmelze (36) durch Erhitzen des Granulats (30) in einem Heizbereich (33) eines Plastifizierzylinders (34) der Spritzgießmaschine (28) auf eine Heiztemperatur (T) von mindestens 170° C,
• Fördern der Schmelze (36) zu einer geschlossenen Düse (38) des Plastifizierzylinders (34),
• Aufbauen eines Einspritzdrucks (p) von höchstens 500 bar in der Schmelze (36),
• Öffnen der Düse (38) und Einspritzen der Schmelze (36) in die Kavität (32), so dass die Leiterplatte (9) umspritzt wird,
• Erstarren der Schmelze (36) zur formstabilen Spritzgussmasse (8).

9. Kunststoffspritzgussverfahren nach Anspruch 8,
**dadurch gekennzeichnet, dass** zwischen mindestens einem der elektrischen Bauelemente (10, 14) und der Leiterplatte (9) ein Zwischenraum (18) gebildet ist, und dass beim Umspritzen ein Teil der Schmelze (36) in den Zwischenraum (18) fließt.

10. Kunststoffspritzgussverfahren nach Anspruch 8 oder 9,
**dadurch gekennzeichnet, dass** eine wannenförmige Gehäuseschale (2) mit der in der Gehäuseschale (2) angeordneten Leiterplatte (9) in die Kavität (32) des Spritzgusswerkzeugs (31) der Spritzgießmaschine (28) angeordnet wird, dass die Schmelze (36) in die Gehäuseschale (2) eingespritzt wird und die Leiterplatte (9) umschließt, und dass die Schmelze (36) in der Gehäuseschale (2) zur Spritzgussmasse (8) erstarrt.

11. Kunststoffspritzgussverfahren nach Anspruch 10,
**dadurch gekennzeichnet, dass** mit der Leiterplatte (9) ein elektrischer Abgang (6) elektrisch verbunden ist, dass die Gehäuseschale (2) eine topfförmige Aufnahme (20) für den Abgang (6) umfasst, dass der in der Aufnahme (20) angeordnete Abgang (6) aus der Gehäuseschale (2) geführt wird, dass in der topfförmigen Aufnahme (20) eine Durchflussöffnung (23) angeordnet ist, und dass beim Einspritzen die Schmelze (36) durch die Durchflussöffnung (23) fließt und sich ringförmig zwischen Abgang (6) und Gehäuseschale (2) legt.

12. Kunststoffspritzgussverfahren nach einem der Ansprüche 8 bis 11,
**dadurch gekennzeichnet, dass** mindestens eines der elektrischen Bauelemente (10, 14) als aktives Bauelement (10) ausgebildet ist, dass eines der aktiven Bauelemente (14) als Lichtelement (11) ausgebildet ist, dass die Spritzgussmasse (8) lichtdurchlässig ist und als Lichtleiter dient, und dass das vom Lichtelement (11) ausgesendete Licht (17) von der Spritzgussmasse (8) geleitet wird.

13. Kunststoffspritzgussverfahren nach einem der Ansprüche 8 bis 12,
**dadurch gekennzeichnet, dass** die Schmelze (36) in höchstens drei Minuten zur formstabilen Spritzgussmasse (8) aushärtet.

14. Kunststoffspritzgussverfahren nach einem der Ansprüche 8 bis 13,
**dadurch gekennzeichnet, dass** nach dem Erstarren der Schmelze (36) zur formstabilen Spritzgussmasse (8) der Verteiler (1) mindestens teilweise mit einer Deckschicht (24) umspritzt wird.

## Claims

1. Electric distributor (1), comprising a trough-shaped housing shell (2),
- with a printed circuit board (9) located within the housing shell (2),
- wherein the printed circuit board (9) supports passive and/or active electric components (10, 14),
- and with an electric outlet (6) electrically connected to the printed circuit board (9),
- wherein the electric outlet (6) is routed through the housing shell (2),
- and wherein the housing shell (2) is filled with a packing material (7), **characterised in that**
- the packing material (7) consists of an injection moulding compound (8) of a thermoplastic elastomer,
- the injection moulding compound (8) is injected into the housing shell (2),
- the injection moulding compound (8) completely encloses the printed circuit board (9) with the electric components (10, 14),
- and the injection moulding compound (8) mechanically joins the printed circuit board (9) to the housing shell (2).

2. Distributor according to claim 1,
**characterised in that** one of the active components (10) is designed as a light element (11) and the housing shell (2) has an exit opening (5) for the light (17), the injection moulding compound (8) being a transparent injection moulding compound (8) and optically guiding the light (17) to the exit opening (5).

3. Distributor according to claim 1 or 2,
**characterised in that** a gap (18) is formed between at least one of the electric components (10, 14) and the printed circuit board (9), and **in that** a part of the injection moulding compound (8) is located in the gap (18).

4. Distributor according to any of claims 1 to 3,
**characterised in that** the trough-shaped housing shell (3) comprises side elements (3) and a base element (4), and **in that** the injection moulding compound (8) is permanently joined to the insides (15) of the side elements (3) and to the inside (16) of the base element (4).

5. Distributor according to any of claims 1 to 4,
**characterised in that** the housing shell (3) comprises a pot-shaped receptacle (20) for the outlet (6), and **in that** a part of the injection moulding compound (8) forms an annular seal (21) bearing against the wall of the pot-shaped receptacle (20) and against the outer wall of the outlet (6).

6. Distributor according to claim 5,
**characterised in that** a through-opening (23) is provided in the pot-shaped receptacle (20), and **in that** the annular seal (21) is joined to the injection moulding compound (8) injected into the housing shell (3) via the through-opening (23).

7. Distributor according to any of claims 1 to 6,
**characterised in that** the distributor (1) is at least partially surrounded by a cover layer (24).

8. Plastic injection moulding method for producing an electric distributor (1)
- with a transparent injection moulding compound (8) of a thermoplastic elastomer,
- and with a printed circuit board (9) fitted with passive and/or active electric components (10, 14),
- wherein the printed circuit board (9) including the electric components (10, 14) is overmoulded with the injection moulding compound (8),
- so that the printed circuit board (9) including the electric components (10, 14) is enclosed by the injection moulding compound (8),
- the method comprising the following steps:
• the placing of the printed circuit board (9) with the electric components (10, 14) in a cavity (32) of an injection moulding tool (31) of an injection moulding machine (28),
• the liquidising of the granulate (30) forming the raw material of the thermoplastic elastomer to produce a melt (36) by heating the granulate (30) in a heating region (33) of a plasticising barrel (34) of the injection moulding machine (28) to a heating temperature (T) of at least 170°C,
• the conveying of the melt (36) to a closed nozzle (38) of the plasticising barrel (34),
• the building-up of an injection pressure (p) of a maximum of 500 bar in the melt (36),
• the opening of the nozzle (38) and the injection of the melt (36) into the cavity (32), so that the printed circuit board (9) is overmoulded,
• the solidifying of the melt (36) to produce a dimensionally stable injection moulding compound (8).

9. Plastic injection moulding method according to claim 8,
**characterised in that** a gap (18) is formed between at least one of the electric components (10, 14) and the printed circuit board (9), and **in that** a part of the melt (36) flows into the gap (18) in the overmoulding process.

10. Plastic injection moulding method according to claim 8 or 9,
**characterised in that** a trough-shaped housing shell (2) with the printed circuit board (9) located in the housing shell (2) is placed in the cavity of the injection moulding tool (31) of the injection moulding machine (28), **in that** the melt (36) is injected into the housing shell (2) and encloses the printed circuit board (9), and **in that** the melt (36) solidifies in the housing shell (2) to form the injection moulding compound (8).

11. Plastic injection moulding method according to claim 10,
**characterised in that** an electric outlet (6) is electrically connected to the printed circuit board (9), **in that** the housing shell (3) comprises a pot-shaped receptacle (20) for the outlet (6), **in that** the outlet (6) located in the receptacle (20) is routed out of the housing shell (2), **in that** a through-opening (23) is located in the pot-shaped receptacle (20), and **in that** the melt (36) flows through the through-opening (23) in the injection process and comes to lie between the outlet (6) and the housing shell (2) in an annular arrangement.

12. Plastic injection moulding method according to any of claims 8 to 11, **characterised in that** at least one of the electric components (10, 14) is designed as an active component (10), **in that** one of the active components (14) is designed as a light element (11), **in that** the injection moulding compound (8) is transparent and acts as a light conductor, and **in that** the light (17) emitted by the light element (11) is conducted by the injection moulding compound (8).

13. Plastic injection moulding method according to any of claims 8 to 12, **characterised in that** the melt (36) hardens in no more than three minutes to form the dimensionally stable injection moulding compound (8).

14. Plastic injection moulding method according to any of claims 8 to 13, **characterised in that**, after the solidification of the melt (36) to form the dimensionally stable injection moulding compound (8), the distributor (1) is at least partially overmoulded with a cover layer (24).

## Revendications

1. Répartiteur électrique (1) avec un boîtier en forme de cuvette (2),
- avec une carte imprimée (9) qui est disposée à l'intérieur du boîtier (2),
- la carte imprimée (9) portant des composants électriques (10, 14) passifs et/ou actifs,
- et avec une sortie électrique (6) qui est reliée électriquement à la carte imprimée (9),
- la sortie électrique (6) traversant le boîtier (2),
- et le boîtier (2) étant rempli d'un matériau de remplissage (7),
**caractérisé**
- **en ce que** le matériau de remplissage (7) se compose d'une masse de moulage par injection (8) en élastomère thermoplastique,
- **en ce que** la masse de moulage par injection (8) est injectée dans le boîtier (2),
- **en ce que** la masse de moulage par injection (8) entoure entièrement la carte imprimée (9) avec les composants électriques (10, 14),
- et **en ce que** la masse de moulage par injection (8) relie mécaniquement la carte imprimée (9) au boîtier (2).

2. Répartiteur selon la revendication 1,
**caractérisé en ce que** l'un des composants actifs (10) est conçu comme un élément lumineux (11), et le boîtier (2) présente une ouverture de sortie (5) pour la lumière (17), la masse de moulage par injection (8) étant une masse de moulage par injection (8) translucide, et la lumière (17) conduisant optiquement à l'ouverture de sortie (5).

3. Répartiteur selon les revendications 1 ou 2,
**caractérisé en ce qu'**un espace intermédiaire (18) est formé entre l'un des composants électriques (10, 14) et la carte imprimée (9), et **en ce qu'**une partie de la masse de moulage par injection (8) se trouve dans cet espace intermédiaire (18).

4. Répartiteur selon l'une des revendications 1 à 3,
**caractérisé en ce que** le boîtier en forme de cuvette (2) comprend des éléments latéraux (3) et un élément de fond (4), et **en ce que** la masse de moulage par injection (8) est reliée solidement aux faces intérieures (15) des éléments latéraux (3) et à la face intérieure (16) de l'élément de fond (4).

5. Répartiteur selon l'une des revendications 1 à 4,
**caractérisé en ce que** le boîtier (2) comprend un logement en forme de godet (20) pour la sortie (6), et **en ce qu'**une partie de la masse de moulage par injection (8) forme un joint d'étanchéité annulaire (21) qui est appliqué contre la paroi du logement en forme de godet (20) et contre la paroi extérieure de la sortie (6).

6. Répartiteur selon la revendication 5,
**caractérisé en ce qu'**une ouverture d'écoulement (23) est formée dans le logement en forme de godet (20), et **en ce que** le joint d'étanchéité (21) est relié par cette ouverture d'écoulement (23) à la masse de moulage par injection (8) versée dans le boîtier (2).

7. Répartiteur selon l'une des revendications 1 à 6,
**caractérisé en ce que** le répartiteur (1) est entouré au moins en partie par une couche de recouvrement (24).

8. Procédé de moulage par injection de matière synthétique pour la fabrication d'un répartiteur électrique (1)
- avec une masse de moulage par injection transparente (8) en élastomère thermoplastique
- et une carte imprimée (9) équipée de composants électriques passifs et/ou actifs (10, 14),
- la carte imprimée (9) avec les composants électriques (10, 14) étant enrobée par injection avec la masse de moulage par injection (8),
- de sorte que ladite carte imprimée (9) avec les composants électriques (10, 14) est entourée par ladite masse de moulage par injection (8),
- avec les étapes de procédé suivantes qui consistent à :
• disposer la carte imprimée (9) équipée des composants électriques (10, 14) dans une cavité (32) d'un moule à injection (31) d'une machine de moulage par injection (28),
• liquéfier le granulat (30) qui sert de matière première pour l'élastomère thermoplastique, pour former une masse fondue (36) en chauffant à une température de chauffe (T) d'au moins 170°C ledit granulat (30) dans une zone de chauffe (33) d'un cylindre de plastification (34) de la machine de moulage par injection (28),
• amener la masse fondue (36) jusqu'à une filière (38) fermée du cylindre de plastification (34),
• constituer une pression d'injection (p) de 500 bar maximum dans la masse fondue (36),
• ouvrir la filière (38) et injecter la masse fondue (36) dans la cavité (32) pour que la carte imprimée (9) soit enrobée par injection,
• faire se solidifier la matière en fusion (36) pour obtenir la masse de moulage par injection (8) de forme stable.

9. Procédé de moulage par injection de matière synthétique selon la revendication 8,
**caractérisé en ce qu'**un espace intermédiaire (18) est formé entre l'un des composants électriques (10, 14) et la carte imprimée (9), et **en ce que** lors de l'enrobage, une partie de la masse fondue (36) s'écoule dans ledit espace intermédiaire (18).

10. Procédé de moulage par injection de matière synthétique selon la revendication 8 ou 9,
**caractérisé en ce qu'**un boîtier en forme de cuvette (2) avec la carte imprimée (9) qu'il contient est disposé dans la cavité (32) du moule à injection (31), **en ce que** la masse fondue (36) est injectée dans le boîtier (2) et entoure la carte imprimée (9), et **en ce que** la masse fondue (36) se solidifie dans le boîtier (2) pour former la masse de moulage par injection (8).

11. Procédé de moulage par injection de matière synthétique selon la revendication 10,
**caractérisé en ce qu'**une sortie électrique (6) est reliée électriquement à la carte imprimée (9), **en ce que** le boîtier (2) comprend un logement en forme de godet (20) pour la sortie (6), **en ce que** la sortie (6) disposée dans le logement (20) est sortie du boîtier (2), **en ce qu'**une ouverture d'écoulement (23) est disposée dans le logement en forme de godet (20), et **en ce que** lors de l'injection, la masse fondue (36) coule à travers l'ouverture d'écoulement (23) et s'applique avec une forme annulaire entre la sortie (6) et le boîtier (2).

12. Procédé de moulage par injection de matière synthétique selon l'une des revendications 8 à 11,
**caractérisé en ce que** l'un au moins des composants électriques (10, 14) est conçu comme un composant actif, **en ce que** l'un des composants actifs (14) est conçu comme un élément lumineux (11), **en ce que** la masse de moulage par injection (8) est translucide et sert de conducteur de lumière, et **en ce que** la lumière (17) émise par l'élément lumineux (11) est guidée par la masse de moulage par injection (8).

13. Procédé de moulage par injection de matière synthétique selon l'une des revendications 8 à 12,
**caractérisé en ce que** la masse fondue (36) durcit en trois minutes au maximum pour former la masse de moulage par injection (8) de forme stable.

14. Procédé de moulage par injection de matière synthétique selon l'une des revendications 8 à 13,
**caractérisé en ce qu'**après la solidification de la masse fondue (36) pour former la masse de moulage par injection (8) de forme stable, le répartiteur (1) est enrobé au moins en partie avec une couche de recouvrement (24).
